# EUROPEAN PATENT APPLICATION

(11) **EP 3 988 380 A1**
(43) Date of publication of application: **27.04.2022**
(21) Application number: 21203791.5
(22) Date of filing: 20.10.2021
(51) Int. Cl.: B60L 53/302

(54) **CHARGING PILE**

(30) Priority: 21.10.2020 CN 202011132542
(71) Applicant: Sungrow Power Supply Co., Ltd., Hefei, Anhui 230088 (CN)
(72) Inventor: XU, Linchong, Hefei, 230088 (CN); YANG, Yuefeng, Hefei, 230088 (CN)
(74) Representative: Zacco Norway AS

(57) **Abstract**

A charging pile is provided by the present disclosure, including: a charging unit and at least one liquid cooling radiator arranged in a box of the charging pile; a power conversion unit of the charging unit is arranged on a contact surface outside the liquid cooling radiator; and the liquid cooling radiator is configured to dissipate heat for the charging unit by means of convective heat exchange of cooling liquid, thereby avoiding need to design a heat dissipation module for each power conversion module in the charging pile and then perform a secondary heat dissipation design on the entire charging pile in the conventional technology, which reduces cost of the charging pile and improves a level of protection of the charging pile.

## Description

### FIELD

The present disclosure relates to the technical field of charging piles, and in particular, to a charging pile.

### BACKGROUND

A power conversion part of a traditional direct current (DC) charging pile is basically designed separately to form a power conversion module. For example, the power conversion module is used as a black box. Different power levels are obtained by paralleling different numbers of power conversion modules, and each power conversion module has its own heat dissipation module. In addition, it is also needed to design secondary heat dissipation for the traditional DC charging pile as a whole according to a heat dissipation method of the traditional DC charging pile. Therefore, a cost is increased invisibly, and a high level of protection is difficult to achieve.

### SUMMARY

In view of this, an objective of the present disclosure is to provide a charging pile, which is used to integrate various components in a charging unit in the charging pile as a whole, to simply a design of heat dissipation, reduce cost of the charging pile and improve a level of protection.

A charging pile is provided in the present disclosure, including: a charging unit and at least one liquid cooling radiator, the charging unit and the at least one liquid cooling radiator being arranged in a box of the charging pile, where,
the charging unit is configured to charge an electrical equipment, and a power conversion unit of the charging unit is arranged on a contact surface outside of the liquid cooling radiator; and
the liquid cooling radiator is configured to dissipate heat for the charging unit by means of convective heat exchange of cooling liquid.

In an embodiment, the charging unit includes: an alternating current (AC) power distribution unit, a power distribution unit, and at least one power conversion unit, where
an input end of the AC power distribution unit is configured to be an input end of the charging unit for receiving AC power supply;
an output end of the AC power distribution unit is connected to an AC side of the power conversion unit; and
each direct current (DC) side of the power conversion unit is respectively connected to multiple input ends of the power distribution unit; and
an output end of the power distribution unit is configured to be an output end of the charging unit.

In an embodiment, in the box:
the power distribution unit and the AC power distribution unit are respectively arranged on both sides of inside of the box; or
the power distribution unit and the AC power distribution unit are arranged on a same side inside of the box.

In an embodiment, a setting mode of the AC power distribution unit and the power distribution unit is any one of the following:
the power distribution unit and the AC power distribution unit are respectively arranged at top and bottom inside of the box;
the power distribution unit and the AC power distribution unit are both arranged at the top or bottom inside of the box;
one of the power distribution unit and the AC power distribution unit is located at front end of the power conversion unit and at the top inside of the box, and the other is located at the bottom inside of the box;
one of the power distribution unit and the AC power distribution unit is located at the front end of the power conversion unit and arranged at the bottom inside of the box, and the other is located at the top inside of the box; and
the power distribution unit and the AC power distribution unit are both located at the front end of the power conversion unit and are respectively located at the top and bottom inside of the box.

In an embodiment, the liquid cooling radiator includes: a housing and cooling liquid;
the power conversion unit is provided in a contact surface outside of the housing and is configured to conduct heat of the power conversion unit; and
the cooling liquid is arranged inside of the housing, and the flowing cooling liquid is used to take away the heat of the housing.

In an embodiment, the power conversion unit includes multiple heating elements;
each of the multiple heating elements of the power conversion unit is respectively arranged on each contact surface outside of the liquid cooling radiator.

In an embodiment, the liquid cooling radiator has a plate shape, and has two contact surfaces.

In an embodiment, the liquid cooling radiator has a polygonal prism structure, and has multiple contact surfaces.

In an embodiment, at least one contact surface of the liquid cooling radiator is provided with at least one of the multiple heating elements of the power conversion unit.

In an embodiment, when there is at least one contact surface of the liquid cooling radiator that is not provided with the heating element, the contact surface of the liquid cooling radiator that is not provided with the heating element is placed against a back plate of the box.

In an embodiment, each contact surface of the liquid cooling radiator is provided with the heating element.

In an embodiment, the liquid cooling radiator is placed in a center, or at a position of a central axis of the box.

In an embodiment, the power conversion unit includes: one rectifier module and n DC/DC converters, where n is an integer greater than 1;
an AC side of the rectifier module is configured to be an input end of the power conversion unit;
a DC side of the rectifier module is connected to input ends of the n DC/DC converters respectively; and
output ends of the n DC/DC converters are respectively configured to be output ends of the power conversion unit.

In an embodiment, the AC power distribution unit includes a switch unit;
A, B, and C three-phase inputs of the AC power supply are connected to input ends of the switch unit in a one-to-one correspondence; and
output ends of the switch unit respectively serve as the output end of the AC power distribution unit.

In an embodiment, the switch unit includes: a drive circuit and an AC relay group,
input ends of the AC relay group are connected to the input ends of the switch unit;
output ends of the AC relay group are connected to the output ends of the switch unit; and
the AC relay group is controlled by the drive circuit.

In an embodiment, the AC relay group includes switch subunits respectively arranged on each phase cable in the AC relay group.

In an embodiment, at least one switch subunit includes at least one relay.

In an embodiment, the at least one switch subunit includes two relays connected in series.

In an embodiment, the switch unit further includes a circuit breaker, and the circuit breaker is arranged between the input ends of the switch unit and the input ends of the AC relay group.

In an embodiment, the AC power distribution unit further includes a lightning arrester;
the A, B, and C three-phase inputs of the AC power supply are grounded through the lightning arrester.

In an embodiment, the charging unit further includes: a centralized control unit configured to:
send a first control signal to the AC power distribution unit to enable the AC power distribution unit to switch on and off;
send a PWM signal to the power conversion unit to enable the power conversion unit to implement electric energy conversion; and,
send a second control signal to the power distribution unit to enable the power distribution unit to implement distribution of output power.

In an embodiment, the charging unit further includes a distributed control unit,
the distributed control unit includes a system controller and multiple sub-controllers; and
each of the sub-controllers is respectively connected to the system controller in communication.

In an embodiment, the charging pile further includes at least one charging gun arranged outside of the box, and the charging unit charges the electrical equipment through the charging gun.

It can be seen from the above technical solutions that the charging pile provided by the present disclosure includes: the charging unit and at least one liquid cooling radiator; both the liquid cooling radiator and the charging unit are arranged in the box; the power conversion unit inside of the charging unit is arranged on the contact surface outside of the liquid cooling radiator; the liquid cooling radiator is configured to dissipate heat for the charging unit by means of convective heat exchange of the cooling liquid, thereby avoiding need to design a heat dissipation module for each power conversion module in the charging pile and then perform a secondary heat dissipation design on the entire charging pile in the conventional technology, which reduces the cost of the charging pile and improves the level of protection of the charging pile.

### BRIEF DESCRIPTION OF THE DRAWINGS

In order to more clearly explain the embodiments of the present disclosure or the technical solutions in the prior art, the drawings used in the description of the embodiments or the prior art will be briefly introduced below. Obviously, the drawings in the following description are merely some embodiments of the present disclosure. For those of ordinary skill in the art, other drawings can be obtained according to the provided drawings without paying creative labor.
Figures 1 to 6 are schematic diagrams of setting position of each unit in a charging pile according to embodiments of the present disclosure;
Figures 7 to 9 are schematic diagrams of the charging pile according to the embodiments of the present disclosure; and
Figures 10 to 16 are schematic diagrams of a charging unit of the charging pile according to the embodiments of the present disclosure.

### DETAILED DESCRIPTION

The technical solution according to the embodiments of the present application will be described clearly and completely as follows in conjunction with the accompany drawings in the embodiments of the present application, so that purposes, technical solutions and advantages of the present application can be more obvious. It is obvious that the described embodiments are only a part of the embodiments according to the present application, rather than all of the embodiments. All the other embodiments obtained by those skilled in the art based on the embodiments in the present application without any creative work belong to the scope of protection of the present application.

In the present application, terms "include", "comprise" or any other variations are intended to cover non-exclusive "include", thus a process, a method, an object or a device including a series of factors not only include the listed factors, but also include other factors not explicitly listed, or also include inherent factors of the process, the method, the object or the device. Without more limitations, a factor defined by a sentence "include one..." does not exclude a case that there is another same factor in the process, the method, the object or the device including the described factor.

A charging pile is provided in an embodiment of the present disclosure, which is used to solve the problem that in the conventional technology, each power conversion module needs its own heat dissipation module, and the traditional direct current (DC) charging pile as a whole also needs to be designed for secondary heat dissipation according to its heat dissipation method, which virtually increase cost and make it difficult to improve a level of protection.

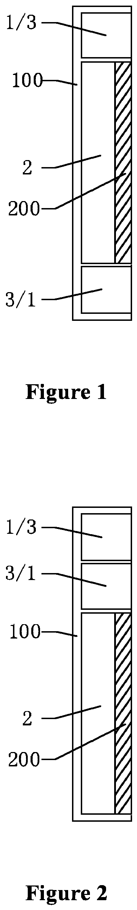

Referring to Figure 1, the charging pile includes: a charging unit (including 1, 2, 3 illustrated in Figure 1) and at least one liquid cooling radiator 200 arranged in a box 100.

The charging unit is configured to charge an electrical equipment. Specifically, the charging unit is directly or indirectly connected to the electrical equipment, so that the charging unit can charge the electrical equipment.

In practical applications, the charging pile may also include at least one charging gun arranged outside of the box 100, and each output end of the charging unit is respectively connected to a corresponding charging gun, and the charging gun is configured to connect the electrical equipment, such as an electric car, so that the charging unit may charge the electrical equipment through the corresponding charging gun.

The power conversion unit 2 inside of the charging unit is arranged on a contact surface outside of the liquid cooling radiator 200; that is, the contact surface outside of the liquid cooling radiator 200 is in contact with the power conversion unit 2, and the power conversion unit 2 and the liquid cooling radiator 200 may conduct heat conduction.

The liquid cooling radiator 200 is configured to dissipate heat for the charging unit by means of convective heat exchange of cooling liquid. Specifically, heat of the power conversion unit 2 is conducted to the contact surface of the liquid cooling radiator 200, the liquid cooling radiator 200 takes away its own heat, so as to implement heat dissipation for the charging unit.

It should be noted that the box 100 may adopt an integral sealing design, or may not adopt the integral sealing design, which is not specifically limited here, and it depends on an actual situation, and all are within the protection scope of the present disclosure.

The power conversion unit 2 in this embodiment does not need to be equipped with a heat dissipation module. For example, the power conversion unit may be an integrated conversion device implemented by connecting multiple DC/DC converters to a rear stage of a rectifier module. An integrated high-power conversion equipment replaces parallel connection of multiple power conversion modules in the conventional technology, and is arranged on the contact surface outside of the liquid cooling radiator 200, and is directly to dissipate heat through the liquid cooling radiator 200, thereby avoiding need to design a heat dissipation module for each power conversion module in the charging pile and then perform a secondary heat dissipation design on the entire charging pile in the conventional technology, so that the cost of the charging pile is reduced. Moreover, there is no need to set up a separate heat dissipation device inside each unit, so the corresponding unit may be sealed separately or integrally sealed with other units, which improves the level of protection of the charging pile.

It is worth noting that a technical source of the power conversion module in the conventional technology is communication power supply, which has a strict requirement on a working environment. The power conversion module is easy to fail in an environment of high temperature, high humidity, high salt spray or strong wind and sand. However, in this embodiment, the charging unit is arranged in a first box with a sealed design, and the liquid cooling radiator dissipates heat for the charging unit, thereby avoiding a problem of failure of the charging unit in the environment of high temperature, high humidity, high salt spray or strong wind and sand.

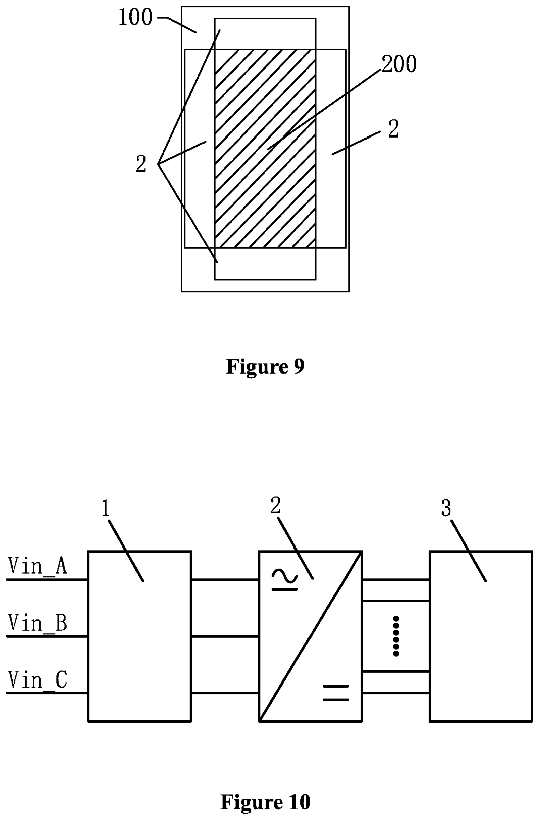

In the above embodiment, referring to Figure 10, the charging unit includes: an alternating current (AC) power distribution unit 1, a power distribution unit 3, and at least one power conversion unit 2.

An input end of the AC power distribution unit 1 serves as an input end of the charging unit of the charging pile for receiving AC power supply. An output end of the AC power distribution unit 1 is connected to an AC side of the power conversion unit 2; each DC side of the power conversion unit 2 is respectively connected to multiple input ends of the power distribution unit 3; and each output end of the power distribution unit 3 serves as each output end of the charging unit of the charging pile for connecting a corresponding charging gun of the charging pile. Specifically, each output end of the power distribution unit 3 provides electrical energy and charges the corresponding electrical equipment, such as an electric car, through the corresponding charging gun.

In any of the above embodiments, positions of the various components in the charging unit may be that the power conversion unit 2 is disposed on a surface of the liquid cooling radiator 200.

The power distribution unit 3 and the AC power distribution unit 1 are respectively arranged on both sides of inside of the box 100, or both are arranged on the same side inside of the box 100.

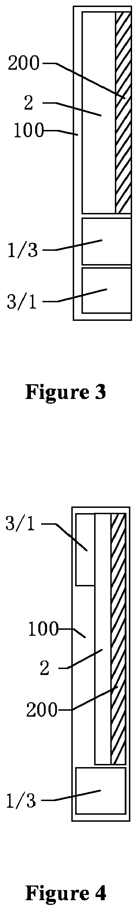

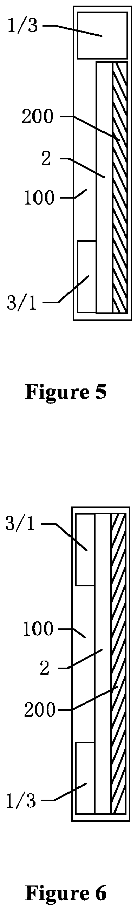

Specifically, a setting mode of the AC power distribution unit 1 and the power distribution unit 3 is any one of the following.
(1) As illustrated in Figure 1, the power distribution unit 3 and the AC power distribution unit 1 are respectively arranged at top and bottom inside of the box. Specifically, as illustrated in Figure 1, the power distribution unit 3 is arranged at the top inside of the box 100, and the AC power distribution unit 1 is arranged at the bottom inside of the box 100; or, the power distribution unit 3 is arranged at the bottom inside of the box 100, and the AC power distribution unit 1 is arranged at the top inside of the box 100.
(2) As illustrated in Figures 2 and 3, the power distribution unit 1 and the AC power distribution unit 3 are both arranged at the top or bottom inside of the box. Specifically, as illustrated in Figure 2, the power distribution unit 3 and the AC power distribution unit 1 are both arranged at the top inside of the box 100; or, as illustrated in Figure 3, the power distribution unit 3 and the AC power distribution unit 1 are both arranged at the bottom inside of the box 100.
(3) As illustrated in Figure 4, one of the power distribution unit 3 and the AC power distribution unit 1 is located at front end of the power conversion unit 2 and at the top inside of the box 100, and the other is located at the bottom inside of the box 100. Specifically, the power distribution unit 3 is located at the front end of the power conversion unit 2 and is set at the top inside of the box 100, and the AC power distribution unit 1 is located at the bottom inside of the box 100; or, the AC power distribution unit 1 is located at the front end of the power conversion unit 2 and is set at the top inside of the box 100, and the power distribution unit 3 is set at the bottom inside of the box 100.
(4) As illustrated in Figure 5, one of the power distribution unit 3 and the AC power distribution unit 1 is located at the front end of the power conversion unit 2 and arranged at the bottom inside of the box 100, and the other is located at the top inside of the box 100. Specifically, the power distribution unit 3 is located at the front end of the power conversion unit 2 and is set at the bottom inside of the box 100, and the AC power distribution unit 1 is located at the top inside of the box 100; or, the AC power distribution unit 1 is located at the front end of the power conversion unit 2 and is arranged at the bottom inside of the box 100, and the power distribution unit 3 is arranged at the top inside of the box 100.
(5) As illustrated in Figure 6, the power distribution unit 3 and the AC power distribution unit 1 are both located at the front end of the power conversion unit 2 and are respectively located at the top and bottom inside of the box 100. Specifically, the power distribution unit 3 is located at the front end of the power conversion unit 2 and is placed at the top inside of the box 100, and the AC power distribution unit 1 is located at the front end of the power conversion unit 2 and is placed at the bottom inside of the cabinet 100; or the power distribution unit 3 is located at the front end of the power conversion unit 2 and is placed at the bottom inside of the box 100, and the AC power distribution unit 1 is located at the front end of the power conversion unit 2 and is placed at the top inside of the box 100.

In this embodiment, integrated design of the charging unit reduces unnecessary redundant design in the traditional charging pile, the whole pile may be made smaller in volume, lighter in weight, and higher in power density.

In any of the above embodiments, the liquid cooling radiator 200 includes a housing and cooling liquid.

A contact surface on outside of the housing is provided with the power conversion unit 2 and is configured to conduct heat of the power conversion unit 2. The cooling liquid is arranged inside of the housing, and the flowing cooling liquid is used to take away the heat of the housing. Specifically, the heat of the power conversion unit 2 is first conducted to the outside of the housing, and then to the inside of the housing. At this time, the cooling liquid provided inside of the housing takes away the heat inside of the housing, and takes away the heat of the power conversion unit 2 because the conductive of heat.

In this embodiment, the power conversion unit 2 adopts an overall design, and the liquid cooling radiator 200 adopts a liquid-cooled design to avoid a conflicting pain point between internal cooling heat dissipation and protection. The level of protection is significantly improved compared with the traditional solution. Due to a better cooling effect of liquid cooling, it is conducive to improvement of the power level.

It should be noted that the power conversion unit 2 includes multiple heating elements. Each of the heating elements is respectively arranged on each contact surface outside of the liquid cooling radiator 200.

The liquid cooling radiator 200 may adopt a double-sided design, that is, there are two contact surfaces that can implement heat exchange. The liquid cooling radiator 200 may also adopt a multi-sided design, that is, there are multiple contact surfaces that can implement heat exchange.

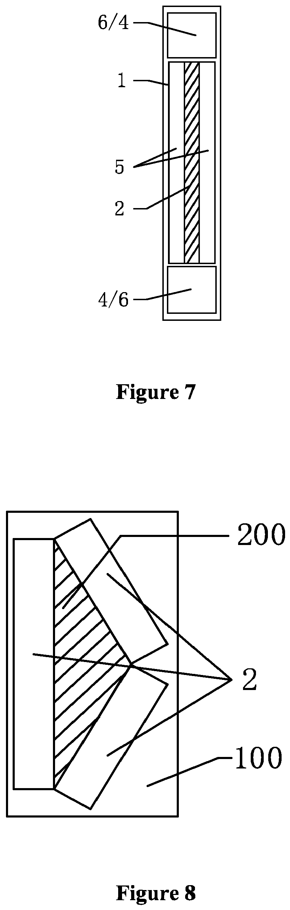

Specifically, when the liquid cooling radiator 200 adopts the double-sided design, as illustrated in Figure 7, the liquid cooling radiator 200 has a plate shape, and the liquid cooling radiator 200 has two contact surfaces. Only one of the two contact surfaces of the liquid cooling radiator 200 is provided with a heating element (as illustrated in Figures 1 to 6); or, both contact surfaces are provided with a heating element (as illustrated in Figure 7). The heat of the power conversion unit 2 is respectively conducted through the two contact surfaces; the cooling liquid in the liquid cooling radiator 200 takes away the heat in the housing, and then takes away the heat from the two heat dissipation surfaces.

When at least one contact surface of the liquid cooling radiator 200 is not provided with the heating element, the contact surface of the liquid cooling radiator 200 that is not provided with the heating element is placed against a back plate of the box 100 (as illustrated in Figures 1 to 6). When heating elements are provided on the two contact surfaces of the liquid cooling radiator 200, the liquid cooling radiator 200 is provided in the center of the box 100, or at a position of a central axis of the box (as illustrated in Figure 7).

It should be noted that the structure illustrated in Figure 7 is only an example of the double-sided design of the liquid cooling radiator 200. The power distribution unit 3 and the AC power distribution unit 1 in the charging unit may be arranged in various ways. For details, refer to the above-mentioned related embodiments, which will not be repeated here, and they are all within the protection scope of the present application.

When the liquid cooling radiator 200 adopts the multi-sided design, as illustrated in Figures 8 and 9, the liquid cooling radiator 200 has a polygonal prism structure, and the liquid cooling radiator 200 has multiple contact surfaces. Specifically, referring to Figure 8, the liquid cooling radiator 200 has a triangular prism structure and has three contact surfaces. Referring to Figure 9, the liquid cooling radiator 200 has a quadrangular prism structure and has four contact surfaces. At least one of the multiple contact surfaces of the liquid cooling radiator 200 is provided with a heating element; of course, it is also possible that the multiple contact surfaces are both provided with a heating element. In order to avoid waste of resources of the liquid cooling radiator 200 and increase in cost and weight, it is preferable that each contact surface is provided with a heating element.

When there is at least one contact surface in the liquid cooling radiator 200 that is not provided with the heating element, the contact surface of the liquid cooling radiator 200 that is not provided with the heating element is placed against the back plate of the box 100 (as illustrated in Figures 1 to 6). When heating elements are provided on the two contact surfaces of the liquid cooling radiator 200, the liquid cooling radiator 200 is provided in the center of the box body 100, or at the position of the central axis (as illustrated in Figure 7).

It should be noted that if the number of power conversion unit 2 in the charging unit is m and the number of heating elements in the power conversion unit 2 is h, then h^{∗}m heating elements are respectively arranged on the corresponding contact surfaces. Specifically, all the heating elements in the same power conversion unit 2 are arranged on the same contact surface. All the heating elements in different power conversion units 2 may be arranged on the same contact surface, for example, the h^{∗}m heating elements are all arranged on the same contact surface. Or, the power conversion unit 2 may be used as a unit. Each power conversion unit 2 is respectively arranged on different contact surfaces, for example, m power conversion units 2 correspond to m contact surfaces one-to-one, and each power conversion unit 2 is respectively disposed on its corresponding contact surface. A specific setting mode of each power conversion unit 2 is not specifically limited here, and it depends on actual situations, and all are within the protection scope of the present disclosure.

In this embodiment, the multiple contact surfaces are provided with heating elements, thereby increasing a contact area between the power conversion unit 2 and the liquid cooling radiator 200, thereby increasing a speed of heat dissipation of the power conversion unit 2.

In the above embodiment, referring to Figure 10, a specific connection relationship in the charging unit is as follows.

The input end of the AC power distribution unit 1 serves as the input end of the charging unit of the charging pile for receiving AC power supply. The AC power may be three-phase AC power. Specifically, the AC power distribution unit 1 has three-phase input ends, which are A-phase input end, B-phase input end, and C-phase input end, respectively, as A-phase input end, B-phase input end, and C-phase input end of the charging unit of the charging pile. The A-phase input end of the AC power distribution unit 1 is used to receive A-phase AC power in the AC power supply, and the B-phase input end of the AC power distribution unit 1 is used to receive B-phase AC power in the AC power supply, and the C-phase input end of the AC power distribution unit 1 is used to receive C-phase AC power in the AC power supply. Of course, the AC power supply may be other phase AC power, such as single-phase AC power. There is no specific limitation here, and it depends on actual situations. The illustrated structure in this embodiment and the specific description of the related devices are all described with three-phase AC power supply as an example. Under other phases of AC power supply, the diagrams and specific descriptions of related devices are similar to the above descriptions and will not be repeated one by one, and they are all within the protection scope of the present disclosure.

The output end of the AC power distribution unit 1 is connected to the AC side of the power conversion unit 2; each DC side of the power conversion unit 2 is respectively connected to multiple input ends of the power distribution unit 3.

In practical applications, the power conversion unit 2 includes: one rectifier module and n DC/DC converters; n is an integer greater than 1. Specifically, the AC power distribution unit 1 has three-phase output ends, namely A-phase output end, B-phase output end, and C-phase output end. The AC side of the rectifier module also has three-phase AC sides, which are A-phase AC side, B-phase AC side and C-phase AC side. The A-phase output end of the AC power distribution unit 1 is connected to the A-phase AC side of the rectifier module, and the B-phase output end of the AC power distribution unit 1 is connected to the B-phase AC side of the rectifier module, and the C-phase output end of the AC power distribution unit 1 is connected to the C-phase AC side of the rectifier module.

A DC side of the rectifier module of the power conversion unit 2 is respectively connected to input ends of the n DC/DC converters of the power conversion unit 2, that is, one rectifier module may be connected to multiple DC/DC converters. In practical applications, the DC/DC converters may be isolated DC/DC converters, so as to realize isolation between high-voltage grid side and user side, as well as isolation between two receiving users during charging, and provide safety of the charging pile.

Output ends of the n DC/DC converters of the power conversion unit 2 are respectively used as output ends of the power conversion unit and are respectively connected to the multiple input ends of the power distribution unit 3. In practical applications, a connection relationship between the output ends of the n DC/DC converters of the power conversion unit and the multiple input ends of the power distribution unit is any one of one-to-one correspondence, many-to-one, and one-to-many. Specifically, the n output ends of the power conversion unit 2 may be connected to the n input ends of the power distribution unit 3 in a one-to-one correspondence. It may also be at least two output ends of the power conversion unit 2, that is, at least two output ends of the DC/DC converter are connected to the input end of the power distribution unit 3. Specifically, there are at least two output ends of the power conversion unit 2 connected in parallel with the input end of the power distribution unit 3, or at least one output end of the at least two power conversion units 2 is connected in parallel with the input end of the power distribution unit 3. There may also be an output end of the power conversion unit 2 connected to multiple input ends of the power distribution unit 3. There is no specific limitation here, and it depends on the actual situation, and they are all within the protection scope of the present disclosure.

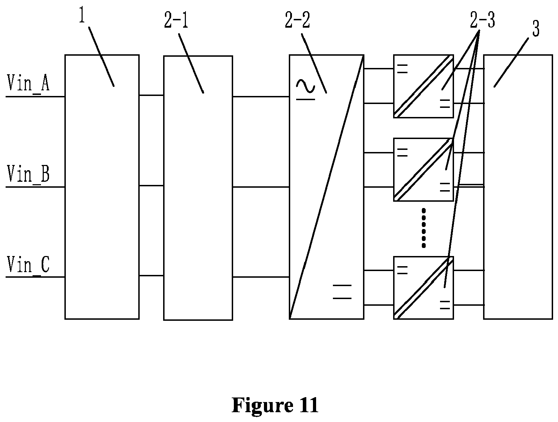

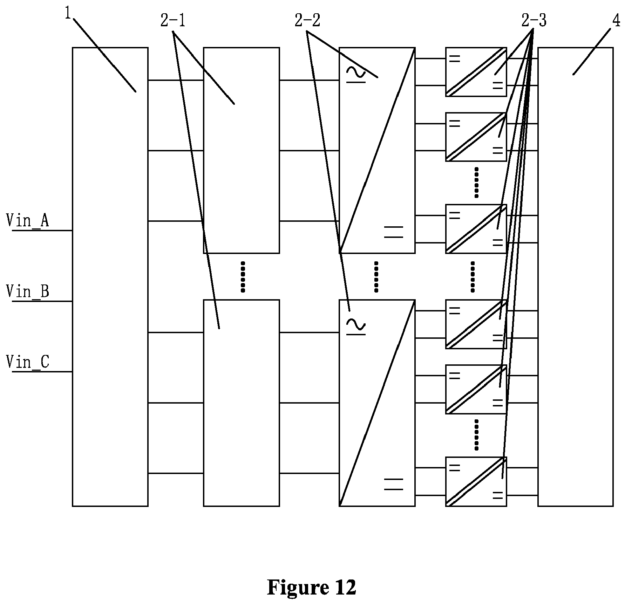

The number of power conversion units 2 may be one (as illustrated in Figure 11), or multiple or two (as illustrated in Figure 12). A specific structure of the power conversion unit 2 will not be repeated here, and they are all protected within range of the present disclosure. It should be noted that if the number of power conversion units 2 in the charging unit is m and the number of DC/DC converters in the power conversion unit 2 is n, the number of DC/DC converters in the charging unit is n ×m; where m is an integer greater than zero.

When the number of power conversion units 2 is one, the AC side of the rectifier module in the power conversion unit 2 is connected to the output end of the AC power distribution unit 1, and the output ends of the n DC/DC converters in the power conversion unit 2 are respectively connected to the corresponding multiple input ends of the power distribution unit 3.

When the number of power conversion units 2 is not one, the AC side of the rectifier module in each power conversion unit 2 is connected to the output end of the AC power distribution unit 1, and the n output ends of the DC/DC converters in each power conversion unit 2, that is, the n×m output ends of the DC/DC converters are respectively connected to the multiple input ends of the power distribution unit 3.

Each output end of the power distribution unit 3 serves as each output end of the charging unit of the charging pile, and is used to charge the electrical equipment. Specifically, each output end of the power distribution unit 3 is connected to the charging gun of the charging pile, and each output end of the power distribution unit 3 is connected to a corresponding electrical equipment, such as an electric car, through a corresponding charging gun, so that the power distribution unit 3 provides charging power for the corresponding electrical equipment.

In practical applications, the power distribution unit 3 includes a multi-channel switch, so that multiple input electric energy of the power distribution unit 3 is output in an independent or series-parallel manner. In other words, the power distribution unit 3 may integrate the electric energy at its input end or directly output it. A specific input-output relationship of the power distribution unit 3 may be that one input in the power distribution unit 3 only provides electric energy for one output, the multiple inputs in the power distribution unit 3 all provide electric energy for one output, or, one input of the power distribution unit 3 provides electric energy for multiple outputs, which will not be repeated here, and they are all within the protection scope of the present disclosure.

This embodiment abandons a traditional scheme of modular stacking, breaks up the modules and recombines them, and no longer uses each module as a black box, but adopts an integrated design idea to connect multiple DC/DC converters through one rectifier module. This embodiment reduces complexity of system, improves integration of the charging pile, and reduces the cost, weight, and volume of the charging pile. Moreover, higher integration level of the rectifier module helps to improve reliability of the rectifier module. The output end of the rectifier module is mounted with multiple DC/DC converters, so that the output power distribution of the power conversion unit 2 may be made finer.

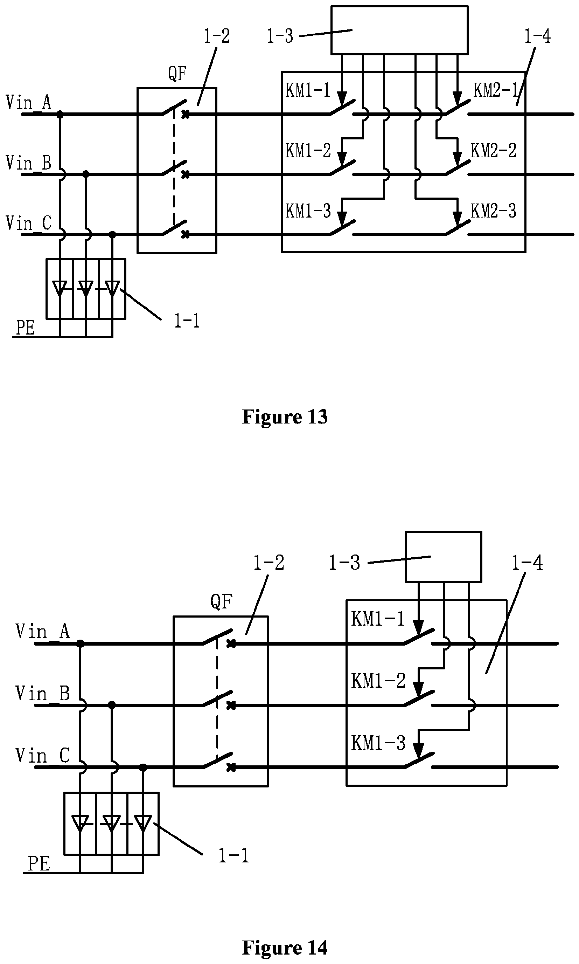

In the foregoing embodiment, the AC power distribution unit 1 includes a switch unit (including 1-2, 1-3, and 1-4 as illustrated in Figure 13).

A, B, C three-phase inputs of the AC power supply, that is, A, B, C three-phase AC cables of the AC power supply, are grounded through a lightning arrester 1-1, and connected to input ends of the switch unit one-to-one correspondence.

In practical applications, the AC power distribution unit 1 also includes the lightning arrester 1-1. The A, B, C three-phase inputs of the AC power supply, that is, the A, B, C three-phase AC cables of the AC power supply, are grounded through the lightning arrester 1-1.

Specifically, the A-phase AC power Vin_A in the AC power supply is connected to an A-phase input end of the lightning arrester 1-1 and an A-phase input end of the switch unit respectively, and the B-phase AC power Vin_B in the AC power supply is connected to a B-phase input end of the lightning arrester 1-1 and a B-phase input end of the switch unit respectively, and the C-phase AC power Vin_C in the AC power supply is connected to a C-phase input end of the lightning arrester 1-1 and a C-phase input end of the switch unit respectively. A ground end of the lightning arrester 1-1 is grounded.

Output ends of the switch unit are respectively used as the output ends of the AC power distribution unit 1. Specifically, A-phase output end, B-phase output end, and C-phase output end of the switch unit are respectively used as the A-phase output end, the B-phase output end, and the C-phase output end of the AC power distribution unit 1.

In practical applications, the switch unit includes: a drive circuit 1-3 and an AC relay group 1-4.

Input ends of the AC relay group 1-4 are connected to the input ends of the switch unit. Specifically, the three-phase input ends of the AC relay group 1-4 are connected to the three-phase AC cables of the AC power supply in a one-to-one correspondence. An output end of the AC relay group 1-4 is connected to the output end of the switch unit. The AC relay group 1-4 is controlled by the drive circuit.

The output end of the AC relay group 1-4 is used as the output end of the switch unit; that is, three-phase output ends of the AC relay group 1-4 are respectively used as the three-phase output ends of the switch unit and are connected in one-to-one correspondence with the three-phase input ends of the power conversion unit 2. It should be noted that the switch unit outputs three-phase AC to the power conversion unit 2. A control end of the AC relay group 1-4 is connected to the drive circuit 1-3, so that the AC relay group 1-4 is controlled by the drive circuit 1-3.

In practical applications, the switch unit further includes a circuit breaker 1-2. The circuit breaker 1-2 is arranged between the input ends of the switch unit and the input ends of the AC relay group 1-4; that is, three-phase input ends of the circuit breaker 1-2 are respectively used as the three-phase input ends of the switch unit, and are respectively connected to the three-phase AC cables of the AC power supply in a one-to-one correspondence. The three-phase output ends of the circuit breaker 1-2 are respectively connected to the three-phase input ends of the AC relay group 1-4 in a one-to-one correspondence.

The aforementioned AC relay group 1-4 includes switch subunits respectively arranged on each phase cable in the AC relay group 1-4. Specifically, a switch subunit is set on A-phase cable of the AC relay group 1-4, a switch subunit is set on B-phase cable of the AC relay group 1-4, and a switch subunit is set on C-phase cable of the AC relay group 1-4.

The switch subunits include at least one relay.

Specifically, the switch subunits may only include one relay (KM1-1, KM1-2 or KM1-3 as illustrated in Figure 14). As illustrated in Figure 14, the drive circuit 1-3 is connected to the relays KM1-1, KM1-1, and KM1-3, respectively. The relays KM1-1, KM1-2 and KM1-3 are all controlled by the drive circuit 1-3, and the drive circuit 1-3 controls the relays KM1-1, KM1-2 and KM1- 3 to complete turn-on and turn-off.

Alternatively, the switch subunits may also include multiple relays connected in series, such as two relays connected in series (as illustrated in Figure 13 KM1-1 and KM2-1, KM1-2 and KM2-2, or KM1-3 and KM2-3). When the switch subunits include multiple relays connected in series, each relay in the switch subunits backs up each other to prevent the switch subunits from being unable to reliably close and open after one of the relays fails. As illustrated in Figure 13, while the drive circuit 1-3 is connected to the relays KM1-1, KM1-2 and KM1-3, it is also connected to the relays KM2-1, KM2-2 and KM2-3. Relays KM1-1, KM1 -2, KM1-3, KM2-1, KM2-2 and KM2-3 are all controlled by the drive circuit 1-3. The drive circuit 1-3 controls two relays in each switch subunit to turn on and turn off at the same time.

In this embodiment, the AC power distribution unit 1 uses the relays for switching, so that the AC power distribution unit 1 has a smaller footprint, lighter weight, and more advantageous cost. In addition, when the switch subunits include multiple groups of relays for switching, switching failures caused by relay adhesion may be prevented.

In practical applications, the rectifier module includes: an EMC circuit 2-1 and an AC/DC converter 2-2 with PFC function.

An input end of the EMC circuit 2-1 is used as the AC side of the rectifier module and is connected to the output end of the AC power distribution unit 1. The EMC circuit 2-1 is used to implement EMC filtering to prevent the clutter or noise generated in the rectifier module from being transmitted to the grid or radiated out through space. An output end of EMC circuit 2-1 is connected to an AC side of AC/DC converter 2-2; a DC side of AC/DC converter 2-2 is used as the DC side of the rectifier module. The AC/DC converter 2-2 is used for AC/DC conversion and power factor control of the AC power supply.

In practical applications, the rectifier module also includes a PFC unit. Specifically, the PFC unit has various forms. The following three forms of PFC unit are explained: the PFC unit is independently installed in a front stage of the AC/DC converter; or, the PFC unit is integrated in the AC/DC converter; or, the AC/DC converter is integrated in the PFC unit. The existence forms of the PFC unit are not specifically limited here, and depend on actual situations, and they are all within the protection scope of the present disclosure.

The PFC unit may be a hardware circuit or a software module. There is no specific limitation here, and it depends on actual situations, and all are within the protection scope of the present disclosure.

It should be noted that the EMC circuit 2-1 has three-phase input and output, and the AC/DC converter 2-2 with PFC function also has a three-phase AC side, so that the charging unit may receive three-phase AC power.

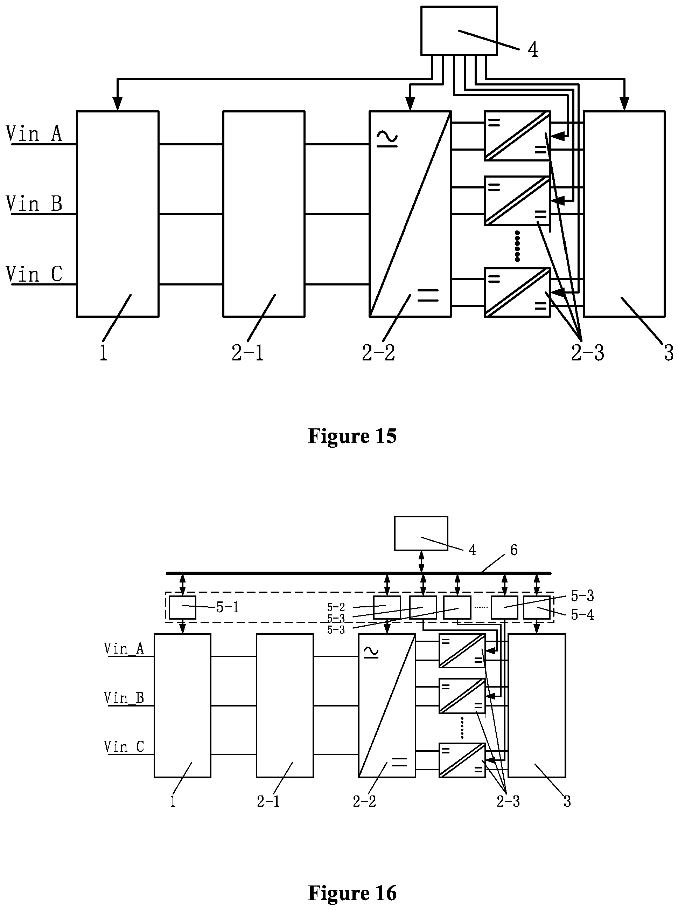

In practical applications, the charging unit may adopt centralized control or distributed control. The centralized control and distributed control are described below.
(1) As illustrated in Figure 15, when the charging unit adopts centralized control, the charging unit further includes a centralized control unit 4. The centralized control unit 4 directly controls the AC power distribution unit 1, the power conversion unit 2, and the power distribution unit 3 to perform corresponding actions respectively.

Specifically, the centralized control unit 4 sends a first control signal to the AC power distribution unit 1 to control on and off of a switching device in the AC power distribution unit 1, so that the AC power distribution unit 1 may switch on and off, and then implement whether the power conversion unit 2 accesses to AC power supply or not. Specifically, the centralized control unit 4 sends the first control signal to the drive circuit 1-3 of the AC power distribution unit 1, and the drive circuit 1-3 controls the corresponding relay to turn on or off according to the first control signal.

The centralized control unit 4 sends a PWM signal to the power conversion unit 2 to control an on-off duty cycle of the switching device in the power conversion unit 2 so that the power conversion unit 2 may implement electric energy conversion. Specifically, the centralized control unit 4 directly controls the on-off duty cycle of the switching device in the AC/DC converter 2-2; and, the centralized control unit 4 directly controls switching frequency and duty cycle of the switch device in each DC/DC converter 2-3.

The centralized control unit 4 sends a second control signal to the power distribution unit 3 to control the on and off of the switching device in the power distribution unit 3, so that the power distribution unit 3 implements the distribution of output power. Specifically, the centralized control unit 4 controls the on and off of a corresponding switch in the power distribution unit 3 according to actual demand, that is, power supply demand of the electrical equipment, so as to realize series-parallel output or independent output of the corresponding DC/DC converter 2-3, to complete output of different voltages and different powers.

(2) As illustrated in Figure 16, when the charging unit adopts distributed control, the charging unit further includes a distributed control unit. The distributed control unit includes a system controller 4 and multiple sub-controllers.

Each sub-controller is respectively connected to the system controller 4 in communication. Specifically, each sub-controller communicates with the system controller 4 through communication bus 6.

It should be noted that each sub-controller may be a relatively simple and low-cost controller to reduce the cost of the charging pile.

In practical applications, each sub-controller includes: a first sub-controller 5-1, m second sub-controllers 5-2, n^{∗}m third sub-controllers 5-3, and a fourth sub-controller 5-4; m is the number of power conversion units 2, and m is a positive integer.

The first sub-controller 5-1 is used to send a control signal to the AC power distribution unit 1 to enable the AC power distribution unit 1 to switch on and off. Specifically, the system controller 4 controller sends an on/off signal to the first sub-controller 5-1 through the communication bus, and the sub-controller controls the AC relay group 1-4 to turn on or off through the drive circuit 1-3 in the AC power distribution unit 1.

The second sub-controllers 5-2 are used to send a PWM signal to the corresponding rectifier module, so that the rectifier module implements power factor control and AC/DC conversion. Specifically, the system controller 4 sends the PWM signal to the second sub-controllers 5-2 through the communication bus, and the second sub-controllers 5-2 control the switching tube of the rectifier module in the power conversion unit 2 to emit waves to implement the exchange for DC conversion. It should be noted that the second sub-controllers 5-2 may be controllers in the rectification module, or controllers independent of the rectification module; there is no specific limitation here, and it depends on actual situations, they are all within the scope of protection of the present disclosure.

The third sub-controllers 5-3 are used to send a PWM signal to the corresponding DC/DC converter 2-3, so that the DC/DC converter 2-3 implements electric energy conversion. Specifically, the system controller 4 sends the PWM signal to the third sub-controllers 5-3 through the communication bus, and the third sub-controllers 5-3 control the switching tube in the DC/DC converter 2-3 to emit waves to implement the DC/DC conversion.

The fourth sub-controller 5-4 is used to send a control signal to the power distribution unit 3 so that the power distribution unit 3 realizes the distribution of output power. Specifically, the system controller 4 controls the on and off of the corresponding switch in the power distribution unit 3 according to the actual demand, that is, the power supply demand of the electrical equipment, so as to implement the series-parallel output or independent output of the corresponding DC/DC converters 2-3 to complete the output of different voltages and different powers.

It should be noted that the distributed control unit and the centralized control unit 4 may also communicate with a host computer through a communication interface, which will not be repeated here, and they are all within the protection scope of the present disclosure.

In this embodiment, the integrated design of each device in the charging unit allows the charging unit to be controlled in multiple ways. The control of the charging unit is mainly completed by the centralized control unit 4 or the system controller 4 in the distributed control unit. The control process is simple.

The features described in the various embodiments in this specification can be replaced or combined with each other, and references may be made among these embodiments with respect to the same or similar portions among these embodiments. Each of the embodiments is mainly focused on describing its differences from other embodiments. Especially, since system embodiments are similar to method embodiments, the description thereof is relatively simple, and reference may be made to the description of the method embodiments for relevant parts. The embodiments of the system and the system described above are only schematic. The above unit described as a separate component may be or may be not separate physically. The component displayed as a unit may be or may be not a physical unit, that is, may be located at one place or may be distributed on multiple network units. The object of the solution of each of the embodiments may be achieved by selecting a part or all of the modules according to the practical needs. The present application can be understood and implemented by those skilled in the art without any creative efforts.

Persons skilled in the art may further realize that, in combination with the embodiments herein, units and algorithm, steps of each example described can be implemented with electronic hardware, computer software, or the combination thereof. In order to clearly describe the interchangeability between the hardware and the software, compositions and steps of each example have been generally described according to functions in the foregoing descriptions. Whether the functions are executed in a mode of hardware or software depends on particular applications and design constraint conditions of the technical solutions. Persons skilled in the art can use different methods to implement the described functions for each particular application, but it should not be considered that the implementation goes beyond the scope of the embodiments of the present disclosure.

Based on the above description of the disclosed embodiments, those skilled in the art are capable of carrying out or using the present application. It is obvious for those skilled in the art to make many modifications to these embodiments. The general principle defined herein may be applied to other embodiments without departing from the scope of the present application. Therefore, the present application is not limited to the embodiments illustrated herein, but should be defined by the broadest scope consistent with the principle and novel features disclosed herein.

## Claims

1. A charging pile, comprising: a charging unit and at least one liquid cooling radiator, the charging unit and the at least one liquid cooling radiator being arranged in a box of the charging pile, wherein,
the charging unit is configured to charge an electrical equipment, and a power conversion unit of the charging unit is arranged on a contact surface outside of the liquid cooling radiator; and
the liquid cooling radiator is configured to dissipate heat for the charging unit by means of convective heat exchange of cooling liquid.

2. The charging pile according to claim 1, the charging unit comprises: an alternating current, AC, power distribution unit, a power distribution unit, and at least one power conversion unit, wherein,
an input end of the AC power distribution unit is configured to be an input end of the charging unit for receiving AC power supply;
an output end of the AC power distribution unit is connected to an AC side of the power conversion unit;
each direct current, DC, side of the power conversion unit is respectively connected to a plurality of input ends of the power distribution unit; and
an output end of the power distribution unit is configured to be an output end of the charging unit.

3. The charging pile according to claim 2, wherein in the box:
the power distribution unit and the AC power distribution unit are respectively arranged on both sides of inside of the box; or
the power distribution unit and the AC power distribution unit are arranged on a same side inside of the box.

4. The charging pile according to claim 3, wherein a setting mode of the AC power distribution unit and the power distribution unit is any one of the following:
the power distribution unit and the AC power distribution unit are respectively arranged at top and bottom inside of the box;
the power distribution unit and the AC power distribution unit are both arranged at the top or bottom inside of the box;
one of the power distribution unit and the AC power distribution unit is located at front end of the power conversion unit and at the top inside of the box, and the other is located at the bottom inside of the box;
one of the power distribution unit and the AC power distribution unit is located at the front end of the power conversion unit and arranged at the bottom inside of the box, and the other is located at the top inside of the box; and
the power distribution unit and the AC power distribution unit are both located at the front end of the power conversion unit and are respectively located at the top and bottom inside of the box.

5. The charging pile according to any one of claims 1 to 4, wherein the liquid cooling radiator comprises: a housing and cooling liquid, wherein,
the power conversion unit is provided in a contact surface outside of the housing and is configured to conduct heat of the power conversion unit; and
the cooling liquid is arranged inside of the housing, and flowing cooling liquid is used to take away heat of the housing.

6. The charging pile according to any one of claims 1 to 4, wherein the power conversion unit comprises a plurality of heating elements;
each of the plurality of heating elements of the power conversion unit is respectively arranged on each contact surface outside of the liquid cooling radiator.

7. The charging pile according to any one of claims 2 to 4, wherein the power conversion unit comprises: one rectifier module and n DC/DC converters, where n is an integer greater than 1;
an AC side of the rectifier module is configured to be as an input end of the power conversion unit;
a DC side of the rectifier module is connected to input ends of the n DC/DC converters respectively; and
output ends of the n DC/DC converters are respectively configured to be output ends of the power conversion unit.

8. The charging pile according to any one of claims 2 to 4, wherein the AC power distribution unit comprises a switch unit;
A, B, and C three-phase inputs of the AC power supply are connected to input ends of the switch unit in a one-to-one correspondence; and
output ends of the switch unit respectively serve as the output end of the AC power distribution unit.

9. The charging pile according to claim 8, wherein the switch unit comprises: a drive circuit and an AC relay group;
input ends of the AC relay group are connected to the input ends of the switch unit;
output ends of the AC relay group are connected to the output ends of the switch unit; and
the AC relay group is controlled by the drive circuit.

10. The charging pile according to claim 9, wherein the AC relay group comprises: switch subunits respectively arranged on each phase cable in the AC relay group.

11. The charging pile according to claim 9, wherein the switch unit further comprises a circuit breaker;
the circuit breaker is arranged between the input ends of the switch unit and the input ends of the AC relay group.

12. The charging pile according to claim 8, wherein the AC power distribution unit further comprises a lightning arrester;
the A, B, and C three-phase inputs of the AC power supply are grounded through the lightning arrester.

13. The charging pile according to any one of claims 2 to 4, wherein the charging unit further comprises a centralized control unit, and the centralized control unit is configured to:
send a first control signal to the AC power distribution unit to enable the AC power distribution unit to switch on and off;
send a pulse width modulation, PWM, signal to the power conversion unit to enable the power conversion unit to implement electric energy conversion; and,
send a second control signal to the power distribution unit to enable the power distribution unit to implement distribution of output power.

14. The charging pile according to any one of claims 2 to 4, wherein the charging unit further comprises a distributed control unit;
the distributed control unit comprises a system controller and multiple sub-controllers; and
each of the sub-controllers is respectively connected to the system controller in communication.

15. The charging pile according to any one of claims 1 to 4, wherein the charging pile further comprises at least one charging gun arranged outside of the box; and
the charging unit charges the electrical equipment through the charging gun.
